Europäisches Patentamt

European Patent Office

Office européen des brevets

(19)

(11) **EP 1 455 308 A1**

(12) ## DEMANDE DE BREVET EUROPEEN

(43) Date de publication:
08.09.2004 Bulletin 2004/37

(51) Int Cl.$^7$: **G06T 17/00**

(21) Numéro de dépôt: **04290607.3**

(22) Date de dépôt: **05.03.2004**

(84) Etats contractants désignés:
**AT BE BG CH CY CZ DE DK EE ES FI FR GB GR HU IE IT LI LU MC NL PL PT RO SE SI SK TR**
Etats d'extension désignés:
**AL HR LT LV MK**

(30) Priorité: **07.03.2003 FR 0302897**

(71) Demandeur: **FRANCE TELECOM**
**75015 Paris (FR)**

(72) Inventeur: **Royan, Jérôme**
**35700 Rennes (FR)**

(74) Mandataire: **Texier, Christian et al**
**Cabinet Régimbeau**
**20, rue de Chazelles**
**75847 Paris cedex 17 (FR)**

(54) **Procédé pour la gestion de la représentation d'au moins une scéne 3D modélisée**

(57)     Procédé pour la gestion de la représentation d'au moins une scène modélisée comprenant des bâtiments destinée à être transmise par des moyens de mémorisation à un client, ladite scène étant modélisée par une représentation multi-échelle arborescente, dans laquelle on associe à différents niveaux de détails de la scène différents noeuds, ces différents noeuds étant dépendants les uns des autres dans une arborescence dans laquelle au moins un noeud fils est défini par des informations connues d'un noeud père et par des informations complémentaires, les informations stockées par les moyens de mémorisation pour le noeud fils étant ces informations complémentaires, caractérisé en ce qu'on met en oeuvre sur la modélisation un traitement de simplification de représentation et en ce qu'on détermine des priorités de mises en oeuvre de traitements de simplification en déterminant une fonction de coût qui prend en compte le critère de la différence de hauteur des bâtiments fusionnés.

Building Tree
(Emprise des bâtiments au sol)

Tableau des
sommets associés

FIG.1

EP 1 455 308 A1

## Description

La présente invention est relative à la représentation d'au moins une scène 3D modélisée.

Elle trouve en particulier avantageusement application à la transmission et à la visualisation de bâtiments via le réseau.

### DOMAINE TECHNIQUE GENERAL

Durant les dernières années, plusieurs techniques ont permis de modéliser automatiquement de vastes environnements urbains à partir d'informations 2D1/2. Parmi ces techniques, on peut citer la segmentation d'image couplée à des méthodes issues de la photogrammétrie, qui permettent à partir d'une vidéo ou de photographies aériennes de déterminer l'altitude, la hauteur, et le type de toit d'un bâtiment, ou encore l'exploitation des systèmes d'informations géographiques (plans cadastraux, images aériennes, ...). A partir de cette représentation 2D1/21/2, comparable à un ensemble de prismes paramétrables, un modèle 3D est reconstruit, permettant de naviguer à l'intérieur de cette ville. D'autres méthodes utilisant des scanners laser fournissent des modèles 3D de villes beaucoup plus détaillés, mais ont l'inconvénient de fournir une multitude d'éléments non structurés (dues aux problèmes d'occlusion), et sont donc difficilement exploitables.

Étant donné la complexité grandissante des modèles de villes virtuelles, il est impossible de transmettre rapidement au client et de rendre en temps réel la totalité d'une scène urbaine modélisée en 3D (plusieurs centaines de milliers de bâtiments pour une ville comme Paris). Par conséquent, le paradigme "télécharge et joue" utilisé de nos jours pour les navigateurs VRML est irréaliste pour de telle scène. Cependant, diverses techniques ont été mises au point pour permettre la navigation au niveau du sol dans de vastes environnements urbains, mais très peu offrent la possibilité de survoler la ville avec une importante profondeur de champs. Cette contrainte de survol est importante, mais n'est pas la seule

- **Compression :** Le modèle 3D d'une ville comme Paris est très volumineux (+8Go), ce qui empêche sa transmission sur le réseau en un faible temps. Il est donc nécessaire de compresser les données transmises au client, afin de transmettre en un minimum de temps l'information lui permettant de naviguer dans la ville.

- **Progressivité :** Il est essentiel que le client est un accès direct à la navigation dès sa connexion au serveur. Le modèle de la ville alors visualisé est grossier, mais a le mérite d'être présent. Ensuite, ce modèle doit être raffiné progressivement, en limitant au maximum les informations redondantes transmises sur le réseau.

- **Localité** : Lors de sa connexion au serveur, le client n'a aucune connaissance globale du modèle (La plupart des applications 3D en réseau, comme certains jeux, ne transmettent en aucun cas la géométrie de la scène, celle-ci étant déjà présente chez le client). Dans notre cas, le client ne doit en aucun cas télécharger la scène dans son intégralité avant de pouvoir la visualiser, mais il doit avoir,la possibilité de naviguer dès sa connexion au serveur.

- **Adaptabilité :** Le raffinement de la scène doit s'effectuer en priorité dans la région proche du point de vue, et doit être réversible.

Un but de l'invention est de proposer une nouvelle représentation des bâtiments d'une ville virtuelle, permettant une transmission progressive de la scène urbaine. Cette représentation est mufti-échelle, permettant ainsi de transmettre au client seulement les détails perceptibles pour un point de vue donné de l'observateur.

### ART ANTERIEUR

Plusieurs techniques ont déjà été proposées pour permettre la visualisation de modèles urbains complexes en local, mais très peu sont adaptées à la visualisation en réseau de scènes urbaines réalistes.

1. *Imposteurs*

Afin de limiter la géométrie à afficher par la carte graphique, une solution consiste a utiliser un rendu hybride associant les représentations géométriques et basées image. Ainsi, pour tous les objets des scènes proches du point de vue, on transmet à la carte graphique leurs représentations géométriques. Pour les objets lointains du point de vue, une représentation basée image est utilisée. Chaque représentation basée image est associée à une région contenant le point de vue (cellule de vue). L'obtention des images ou imposteurs associés à une cellule de vue est effectuée par projection de la géométrie lointaine sur des plans entourant la cellule de vue. Le problème posé par cette technique est l'apparition d'artefacts dus aux effets de parallaxe engendrés par la projection perspective. Pour parer ce problème, la solution d'imposteurs maillés multiples permet de limiter ces apparitions d'artefacts [2]. Une autre solution est l'utilisation d'imposteurs basés points, ou l'image est représentée par un ensemble de points 3D *[14]*. Toutefois, toutes les représentations basées images ont l'inconvénient d'être trop volumineuses pour une transmission sur réseau (transfert coûteux d'images, de maillages, ou d'une multitude de points).

## 2 *Rendu basé point*

Dans le but de traiter uniquement des points, et non plus des triangles, le rendu basé point utilise une représentation non pas polygonale, mais une représentation constituée d'un ensemble de points (surfels) sans connectivité explicite, auxquels sont associés différents attributs de profondeur, de couleur, de normale, etc... [10]. L'intérêt de cette représentation est la rapidité des traitements effectués lors de la phase de rendu 3D étant donné la simplicité des primitives. Il est nécessaire qu'au moins un point soit projeté sur chaque pixel. Dans le cas contraire, un lissage est effectué afin de combler les pixels vides.

Cette technique est très appropriée à des objets aux courbures complexes, et dont la distance du point de vue à l'objet par rapport à sa dimension est assez importante. Dans le cas d'une navigation au niveau du sol dans une ville, la distance du point de vue aux bâtiments par rapport à la taille des bâtiments est assez réduite. De plus, un bâtiment est constitué de très peu de polygones (façades + toit), et les textures plaquées sont assez détaillées. Pour obtenir de bons résultats avec une représentation basée point, il faudrait une résolution de surfels très importante pour chaque bâtiment. Étant donné le nombre important de bâtiments dans une ville, la taille de la base de données de la ville en représentation basée point serait beaucoup trop volumineuse pour être stockée sur le serveur et transmise au client.

## 3 *Visibilité conservative*

Le but de cette technique est de limiter la géométrie transmise à la carte graphique, en calculant la géométrie visible depuis un certain point de vue, ou une région (cellule de vue). Lors d'une navigation au niveau du sol dans une ville, la plupart des bâtiments proches du point de vue masquent les bâtiments plus lointains. Ainsi, le nombre de bâtiments visibles est très limité par rapport au nombre de bâtiments de la scène, et seuls ces bâtiments seront transmis à la carte graphique.

Certaines techniques permettent de calculer en temps réel ces ensembles d'objets potentiellement visibles depuis un certain point de vue (PVS) en exploitant le matériel graphique [15] [16]. Dans le cas d'une application client/serveur, seul le serveur a une connaissance globale de la scène, et c'est donc du coté serveur que devra être effectué les calculs de PVS, ce qui donnerait des résultats très peu satisfaisants dans le cas d'un grand nombre de clients connectés.

Une autre solution est de pré-calculer ces objets potentiellement visibles depuis une région donnée (cellule de vue). En effet, il suffit de partitionner l'espace navigable *2D1/2* de la scène urbaine en cellule de vue, et de calculer l'ensemble des objets potentiellement visibles depuis ces cellules de vue *[12] [17]*. Dans le cas d'une application en réseau, le client n'a plus qu'à transmettre sa position au serveur, qui détermine la cellule de vue correspondante, et transmet la géométrie visible depuis celle-ci. Le serveur n'a plus de calcul d'occlusion à effectuer, mais joue plutôt le rôle de base de données structurée qui répond aux requêtes des clients.

Toutefois, dans le cas d'un survol de scènes urbaines, la grande majorité des bâtiments d'une ville sont visibles, et donc plus l'altitude du point de vue augmente, plus les PVS associés au point de vue deviennent importants. Cette technique de visibilité conservative est donc adapté à une navigation au niveau du sol, mais est inutilisable dans le cas d'un survol de villes.

## 4 *Niveaux de détails*

La taille d'un objet dans l'image dans le cas d'une projection perspective dépend entièrement de sa taille réelle dans l'espace 3D, et de sa distance par rapport au point de vue. Ainsi, plus l'objet sera distant du point de vue, plus sa taille dans l'image sera réduite. Or, conserver la géométrie complexe d'un objet constitué d'un grand nombre de polygones est inutile dans le cas ou sa projection dans l'image ne couvre que quelques pixels. C'est pourquoi il peut être intéressant de proposer plusieurs représentations d'un même objet 3D à différentes résolutions: *le niveau de détail.*

La plupart des méthodes de simplification s'appliquent à des objets maillés *[1] [3]* [4] [11], ou sont effectuées manuellement lors de la modélisation d'objets 3D (par exemple lors de la modélisation de bâtiments). Pour décimer un maillage, on applique successivement des opérations atomiques comme la contraction d'arête ou la suppression de sommet tout en approchant au mieux la surface d'origine. Il est possible d'obtenir une représentation multi-échelle progressive en utilisant une structuration sous forme d'arborescence [6] [5] *[7] [8],* où chaque noeud de l'arbre correspond à une opération atomique appliquée au maillage. Cette représentation multi-échelle est dans ce cas progressive et réversible, et la sélection des noeuds à développer peut dans ce cas dépendre du point de vue.

Seulement, un bâtiment de ville ne peut pas être considéré comme un objet maillé, mais plutôt comme un ensemble restreint de polygones. De plus, il n'est pas envisageable d'appliquer des simplifications aux bâtiments pris un à un, mais plutôt à la ville dans sont intégralité. La plateforme de navigation urbaine *Nexus* de l'université de Stuttgart utilise les niveaux de détails statiques pour les bâtiments, mais ne propose pas une représentation progressive et dynamique multi-échelle d'une ville *[13].*

## 5 *Modèles procéduraux*

Une autre solution est de modéliser la ville de manière procédurale à l'aide de techniques issues des *L-system [9].* A partir d'un certain nombre de paramètres, comme la répartition de la densité démographique, l'orientation générale des rues, la définition des zones constructibles, Il est possible de modéliser automatiquement une ville. L'intérêt pour une application client/serveur est le peu d'informations à transmettre afin d'obtenir le modèle d'une ville. L'inconvénient de cette représentation est le manque de réalisme du modèle 3D de la ville.

## PRESENTATION DE L'INVENTION

La présente invention propose une représentation multi-échelle des bâtiments d'une ville qui est progressive, qui peut être dépendante du point de vue, et peu volumineuse, afin de permettre une navigation urbaine en survol sur un système client/serveur. Cette invention n'est pas uniquement restreinte à la représentation de bâtiments, mais permet de représenter toutes scènes 3D modélisées à parti d'un ensemble de prismes.

La modélisation de villes constituées de plusieurs centaines de milliers de bâtiments nécessite d'être effectuée automatiquement, afin de limiter les coûts de production. Ainsi que cela est exposé plus haut, ces méthodes de modélisation automatique sont souvent basées sur une représentation *2D1/21/22* des bâtiments. Il est donc intéressant de conserver cette représentation *2D1/21/22* de la ville, représentant un volume de données beaucoup moins important que la représentation 3D correspondante (taux de compression de 1:10). Cette représentation *2D1/21/22* multi échelle et progressive de la scène sera transmise au client, qui devra se charger de la reconstruction 3D correspondante. Rappelons que cette représentation respecte, dans le cadre d'une utilisation en réseau, les contraintes suivantes

- **Compression :** Permettant de transmettre en un minimum de temps sur des réseaux à faible débits l'information nécessaire à la reconstruction 3D des bâtiments.

- **Progressivité :** Permettant d'avoir un maximum de niveaux de détail, limitant les ruptures dans l'image dues au passage d'un niveau au suivant. De plus, on limite les redondances entre les différents niveaux de détails, puisque seul l'information nécessaire permettant de raffiner la scène sera transmise (contrairement aux niveaux de détail statiques qui retransmettent l'intégralité des objets aux différentes résolutions sans exploiter les niveaux de détail précédents).

- **Localité** : Lors de sa connexion au serveur, le client n'a aucune connaissance globale du modèle. Dans notre cas, le client n'a pas besoin de télécharger la scène dans son intégralité avant de visualiser celle-ci, mais il peut naviguer dès sa connexion au serveur.

- **Adaptabilité et dépendance du point de vue :** Le raffinement de la scène s'effectue en priorité dans la région proche du point de vue, et doit être réversible. La vitesse de raffinement de la scène dépend du débit du réseau, et ainsi plus le débit est important, plus la mise à jour de la scène est rapide.

- **Survol:** Permettant une navigation dans les aires, contrairement aux solutions proposées par les méthodes de visibilité conservative.

Pour cela, il est proposé de représenter l'ensemble des prismes multi-échelle représenté en *2D1/2* à l'aide d'une arborescence. Ces prismes ne sont pas connexes ; on sort ainsi du cadre de la simplification de maillages 3D stockés sous forme d'un « *vertex tree* » [8], [5]. Les simplifications effectuées auront pour but de diminuer le nombre de sommets définissant les prismes par suppression de sommets ou fusion de prismes.

Ainsi, l'invention propose un procédé pour la gestion de la représentation d'au moins une scène modélisée comprenant des bâtiments destinée à être transmise par des moyens de mémorisation à un client, ladite scène étant modélisée par une représentation multi-échelle arborescente, dans laquelle on associe à différents niveaux de détails de la scène différents noeuds, ces différents noeuds étant dépendants les uns des autres dans une arborescence dans laquelle au moins un noeud fils est défini par des informations connues d'un noeud père et par des informations complémentaires, les informations stockées par les moyens de mémorisation pour le noeud fils étant ces informations complémentaires, caractérisé en ce qu'on met en oeuvre sur la modélisation un traitement de simplification de représentation et en ce qu'on détermine des priorités de mises en oeuvre de traitements de simplification en déterminant une fonction de coût qui prend en compte le critère de la différence de hauteur des bâtiments fusionnés

Lesdits moyens de mémorisation peuvent être un serveur ou tout autre moyen de mémorisation équivalent (CD ROMs, par exemple)

## PRESENTATION DES FIGURES

- La figure 1 est une représentation des niveaux de détail à l'aide d'un arbre polygonal ;
- La figure 2 illustre un exemple de triangulation contrainte par les emprises au sol des bâtiments ;
- La figure 3 illustre un exemple de simplifications ;
- La figure 4 illustre un principe de l'algorithme de génération d'une représentation progressive de ville ;
- La figure 5 illustre un modèle d'un système client serveur de navigation temps dans un environnement urbain ;
- La figure 6 illustre un algorithme de sélection des noeuds à visualiser.

## DESCRIPTION D'UN OU PLUSIEURS EXEMPLES DE MISE EN OEUVRE

On présente dans cette section les informations *2D1/21/2'* représentant l'ensemble des bâtiments fournis par la plupart des algorithmes de modélisation automatique de ville, permettant ainsi de spécifier la représentation multi-échelle progressive mise en oeuvre.

Ensuite l'algorithme permettant de générer cette représentation multi-échelle progressive est présenté.

Enfin, nous proposons un exemple d'utilisation de cette représentation sur un système de visualisation et de navigation dans de vastes environnements urbains en réseaux.

## 1 Représentation 2D1/2 des bâtiments d'une ville

La modélisation d'une ville ne peut se faire manuellement étant donné le nombre important de bâtiments la constituant. La plupart des techniques de modélisation automatique de ville permettant, à partir d'informations 2D1/2 (vidéos, photographies, plans cadastraux, ...), d'extraire l'information 2D1/2 nécessaire permettant de reconstruire par extrusion le modèle 3D de la ville (segmentation de l'image déterminant les emprises au sol des bâtiments, et techniques issues de la photogrammétrie fournissant leurs altitudes et leurs hauteurs). Ainsi, les bâtiments d'une ville peuvent être représentés comme étant un ensemble d'emprises au sol de bâtiments, auquel sont associés respectivement divers paramètres tels que leur hauteur, leur altitude, leur texture de façade, leur type de toit,... La représentation 2D1/2 des bâtiments de la ville est beaucoup plus adaptée à la transmission d'une ville en réseau (uniquement les sommets 2D1/2 de l'emprise au sol des bâtiments ainsi que les paramètres permettant la modélisation 3D), offrant ainsi un taux de compression de 1:10 par rapport à la représentation 3D correspondante. Cependant, une phase de modélisation 3D est donc nécessaire chez le client afin de transmettre la géométrie des bâtiments à la carte graphique.

Cependant, cette représentation 2D1/2 doit respecter quelques contraintes topologiques afin d'appliquer plus aisément les simplifications :

- une emprise au sol de bâtiment ne peut s'intersecter, ni intersecter un autre bâtiment ;
- une emprise au sol de bâtiment ne peut en toucher une autre qu'en "partageant" des segments communs (points tangentiels interdits) .
- pas de duplication de sommets définissant les emprises au sol des bâtiments.

Les bases de données générées à partir d'informations 2D1/2 ne respectent pas toujours ces contraintes, c'est pourquoi des outils de correction automatique ont été mis en oeuvre afin de les corriger (tests d'intersections, interface de correction, ...).

## 2 Représentation multi-échelle progressive des bâtiments d'une ville

### 2.1 Contexte

Soit S l'ensemble des sommets dans $R^2$ de notre scène représentée en 2D1/22, et soit P appartenant à $S^n$ l'ensemble des ploygones représentables à partir de l'ensemble S. On définit par *BFP E* P l'ensemble des emprises au sol des bâtiments de notre scène. L'idée va donc être d'appliquer une séquence de simplification à *BFP :*

$$(\widehat{BFP} = BFP^n) \xrightarrow{simpl_{n-1}} \ldots \xrightarrow{simpl_1} BFP^1 \xrightarrow{simpl_0} BFP^0 \qquad (1)$$

Etant donné que chaque simple est inversible, ce processus l'est aussi :
Equation (2)

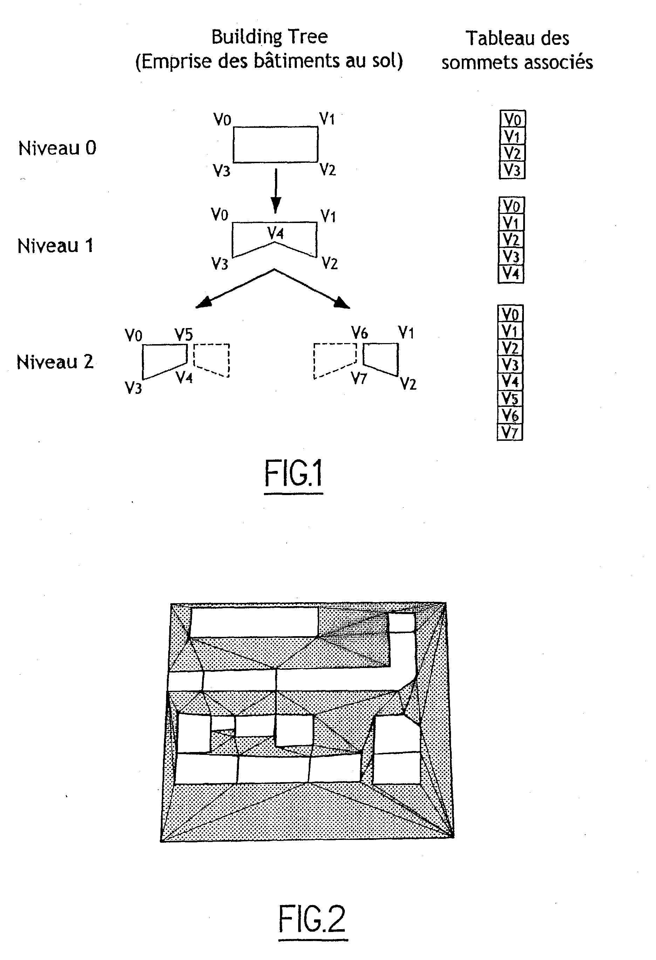

Le tuple *(BFPo, (dvlpo, ...,dvlp",_1})* forme une représentation progressive et multi-échelle de *BFP.* Chaque développement *dvlp* introduit l'ajout de sommets ainsi que la modification de certaines emprises au sol de bâtiments (voir fig. 1). Le tuple *(fbfpi,...,bfpi+,1},bfpj)* définit une simplification *simplk_1 où fbfpi,...,bfpi+,1,J* représente les emprises au sol de bâtiments appartenant à *BFP^k* *et b f pj* le bâtiment simplifié correspondant appartenant à *BFP^{k-1}.* Respectivement, le tuple *(bfpj,{bfpi,...,bpfi+,,,})* représente un développement *dvlpk.*

La séquence résultante des emprises au sol de bâtiments *BFPo, .... BFpn* est particulièrement bien adaptée à une sélection de niveau de détail dépendant du point de vue. En addition, l'utilisation de *géomorphes* peut-être envisageable afin d'obtenir visuellement des transitions plus homogènes entre les différents niveaux de détail.

### 2.2 Représentation multi-échelle

La représentation multi-échelle des bâtiments d'une ville se base sur une structure arborescente contenant les fusions et simplifications des bâtiments Le *Building tree.* A cette arbre est associé un tableau des sommets définissant les emprises au sol des bâtiments associés aux noeuds du *Building tree* (appelés *Building Nodes).* L'interêt du *Building tree,* réside dans le stockage d'informations non redondantes entre les différents noeuds, et d'une transmission progressive envisageable à partir de cette représentation. En effet, pour développer un noeud père du *Building tree, il* n'est pas nécessaire de stocker l'intégralité des informations permettant de représenter les noeuds fils, mais seulement l'informations complémentaires qui, à partir des informations déjà connues du noeud père permet de déterminer les noeuds, fils. Aussi, pour éviter toutes transmissions au client de sommets inutiles pour la suite du développement du *Building tree,* tout sommet définissant l'emprise au sol d'un noeud du *Building tree,* définit l'emprise au sol d'au moins un de ces noeuds fils(voir fig 1). Chaque *Building node* doit contenir une représentation 2D1/22 permettant une modélisation 3D du bâtiment qui lui est associé. Ainsi, un *Building node* doit être défini comme tel:

-   une référence,
-   une emprise au sol (polygone indexé par rapport au tableau des sommets),
-   une hauteur,
-   une altitude,
-   un type de toit,
-   tout autres paramètres permettant de modéliser de manière procédurale la géométrie 3D du bâtiment,
-   les références vers le noeud père et les noeuds fils.

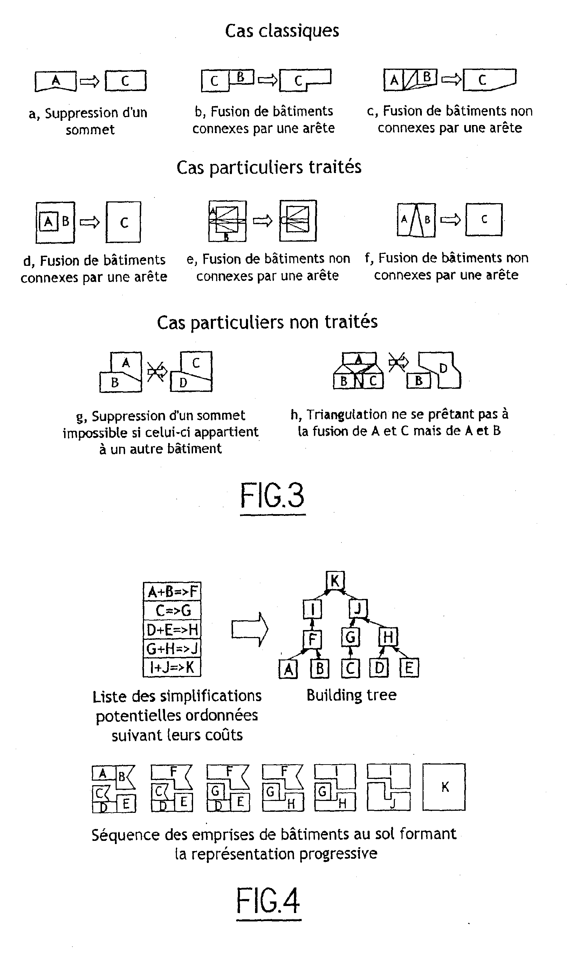

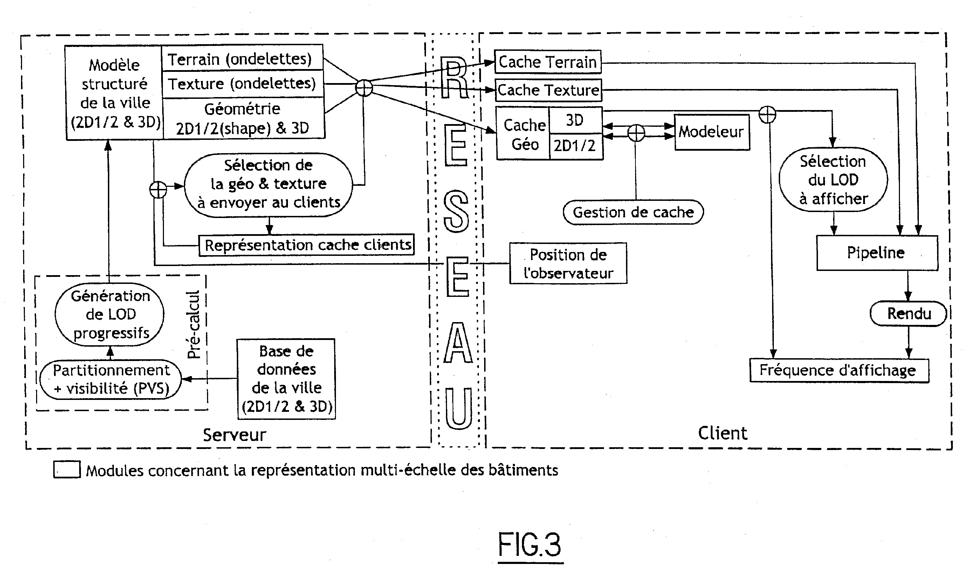

Cette représentation des bâtiments d'une ville sous forme d'un *Building tree* permet de transmettre au client les détails réellement perceptibles pour un point de vue donné. En effet, suivant différents critères comme la distance du point de vue à un bâtiment représenté par un *Building Node,* le serveur peut décider de transmettre l'information nécessaire permettant au client de développer celui-ci, et donc d'afficher un modèle plus raffiné du bâtiment. Le serveur à connaissance de l'intégralité du *Building tree* (dont les feuilles représentent les bâtiments fournis en entrée de l'algorithme), alors que le client n'a connaissance que d'une partie du *Building tree.* Cette représentation sous forme d'arborescence introduit une contrainte sur le processus de génération de niveaux de détails. En effet, a chaque simplification effectuée, un et seulement un seul *building node* peut être est généré (voir le cas particulier *g* de la fig 3):

$$\forall k, \exists i,j \setminus i \neq j, bfp_j \in BFP^{k-1}, bfp_j \in BFP^{k-1}, bfp_i \notin BFP^k, bfp_j \notin BFP^k \qquad (3)$$

Ainsi, une simplification de un ou plusieurs bâtiments ne génére qu'un seul bâtiment.

## 3 Génération de la représentation multi-échelle progressive

### 3.1 Simplifications envisageables

Les simplifications envisageables permettant de limiter la complexité de la ville sont les suivantes

- Réduction du nombre de façades d'un bâtiment: S'effectue par la suppression d'un sommet de l'emprise au sol du bâtiment, et vérifie ces contraintes:

    - Un seul sommet est supprimé à chaque réduction du nombre de facades d'un bâtiments, de plus ce sommet ne doit pas être partagé par une autre emprise au sol de bâtiment.

$$
\begin{aligned}
&\forall simpl(\{bfp_i\}, bfp_j) \text{ avec } bfp_i \in BFP^k \text{ et } bfp_j \in BFP^{k-1} \\
&\text{alors } \exists! \; v \in bfp_i \setminus v \notin bfp_j \\
&\text{de plus } \nexists l \setminus l \neq i, v \in bfp_l, \text{ avec } bfp_l \in BFP^k
\end{aligned} \tag{4}
$$

    - La suppression du sommet ne doit pas engendrer d'intersections entre le bâtiment simplifié et les bâtiments avoisinants.

$$
\forall k, \forall bfp_i, bfp_j \in BFP^k, i \neq j \Rightarrow bfp_i \cap bfp_j = \emptyset \tag{5}
$$

    - L'aire de l'emprise au sol du bâtiment simplifié doit être la plus proche de l'aire de l'emprise au sol du bâtiment originale.

$$
\forall simpl(\{bfp_i\}, bfp_j), \exists! v_1 \in bfp_i, v_1 \notin bfp_j \Rightarrow \forall v_2 \in bfp_i, v_1 \neq v_2,
$$

$$
area(bfp_j) = area(bfp_i - \{v_1\}) \leq area(bfp_i - \{v_2\}) \tag{6}
$$

- **Fusion de deux bâtiments connexes par une façade:** S'effectue par la fusion des emprises au sol des deux bâtiments. La hauteur du bâtiment résultant est une moyenne de la hauteur des deux bâtiments pondérée par leurs surfaces respectives, et l'altitude est l'altitude minimale des deux bâtiments originaux, assurant ainsi au bâtiment généré d'être plaqué au sol:

$$
\begin{cases}
altitude(bfp_k) = MIN(altitude(bfp_i), altitude(bfp_j)) \\
hauteur(bfp_k) = \frac{hauteur(bfp_i) * area(bfp_i) + hauteur(bfp_j) + area(bfp_j)}{area(bfp_i) * area(bfp_j)}
\end{cases} \tag{7}
$$

- **Fusion de deux bâtiments non connexes:** Cette simplification est beaucoup moins implicite que les deux précédentes. Pour déterminer les fusions potentielles de bâtiments non connexes par une arête, on effectue une triangulation de l'espace vide sans point de *Steiner* (les sommets des triangles appartiennent à l'ensemble V, et donc la triangulation n'est pas de Delaunay, voir fig 2). Ainsi, nous obtenons un maillage composé des emprises au sol des bâtiments et des triangles issues de la triangulation de l'espace vide, qui nous fournie une topologie complète de la scène. La fusion entre deux bâtiments non connexes ne peut s'effectuer qu'à la condition d'avoir des triangles partageant un sommet avec chacun des deux bâtiments, et qui soient connexes par une arête à au moins un des bâtiments (voir fig 3). l'altitude et la hauteur du bâtiment généré suit toujours l'équation 7. *Il* est a noter que cette méthode de détermination des fusions possibles entre bâtiments non connexes n'est pas restrictive. D'autres méthodes, comme la recherche des arêtes d'emprise au sol de bâtiments les plus proches peuvent être envisagée, ou l'expansion de ces emprises au sol. Seulement, le but est de limiter le nombre de sommets ajoutés afin de définir les fusions des bâtiments (sommets qui risqueraient d'être impertinents pour des niveaux de détails plus raffinés).

La figure 3 nous montre différents cas de simplifications possibles. L'utilisation d'une triangulation permet de résoudre les cas particuliers e et f, mais à l'inconvénient de ne pas prendre en compte toutes les simplifications possibles, comme dans le cas h (ce cas assez rare ne bloque en aucun cas le processus de simplification, mais il ne permet pas de simplifier en priorité les bâtiments les plus proches). Le cas g quant à lui est impossible, car il ne vérifie pas la contrainte posée par l'équation 3.

### 3.2 Algorithme de simplification

L'algorithme de simplification prend en entrée l'ensemble des bâtiments représentés en 2D1/22, afin de générer le *building tree* correspondant. L'initialisation de l'algorithme s'effectue par une affectation aux feuilles du *building tree* de tous les bâtiments en entrée, et par une recherche de toutes les simplifications potentielles. Seulement, pour déterminer quelle simplification doit être effectuée en priorité, une fonction de coût leurs est affectée. Cette fonction de coût doit prendre en compte les différents critères suivants :

- La différence de hauteur des bâtiments fusionnés *(difj' hauteur),* afin de fusionner en dernière priorité, par exemple, une tour voisine d'une petite résidence.
- La différence d'altitude des bâtiments fusionnés *(diff-altitude),* afin de fusionner en dernière priorité par exemple un bâtiment situé au pied d'une falaise, avec son voisin situé au sommet de celle-ci.
- La surface supplémentaire engendrée par la fusion (area), car plus cette surface est importante, plus cette fusion sera visible lors de la visualisation, entraînant une rupture d'animation *(popping effects).*
- La distance minimale entre les bâtiments fusionnés *(dist_min),* permet la conservation des rues lors du processus de simplification. Cette distance est indirectement prise en compte par la surface supplémentaire engendrée mais, dans le cas d'une fusion de deux bâtiments couvrant une faible surface et assez distants l'un de l'autre (deux cabanes de part et d'autre d'une rue), la surface supplémentaire générée est assez faible, mais la conservation des rues est rompue. La simplification qui est effectuée en priorité est celle qui à le coût le plus faible, sachant que la fonction de coût doit respecter cette propriété :

$$\text{minimiser } cout(diff\_hauteur, diff\_altitude, dist\_min, area) \Leftrightarrow \begin{cases} \text{Minimiser } diff\_hauteur \\ \text{Minimiser } diff\_altitude \\ \text{Minimiser } dist\_min \\ \text{Minimiser } area \end{cases}$$
$$(8)$$

La fonction de coût utilisée dans notre mise en oeuvre est la suivante :

$$cout(diff\_hauteur, diff\_altitude, dist\_min, area) = area \times e^{a \times diff\_hauteur + \beta \times diff\_altitude + \gamma \times dist\_min} \qquad (9)$$

Où $\alpha$, $\beta$, $\gamma$ sont des scalaires permettant de prendre plus ou moins en compte les différents paramètres *diffJzauteur, diff_altitude, dist_min, area.*

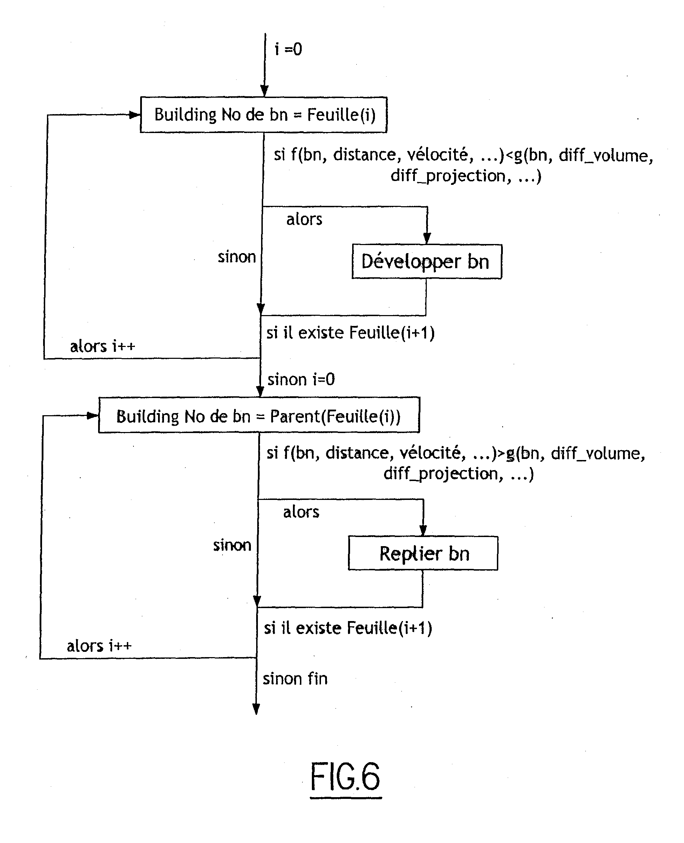

Ainsi, durant tout le déroulement de l'algorithme, une liste des simplifications potentielles ordonnée selon leurs coûts est maintenue à jour. A chaque itération, la première simplification de la liste est effectuée, ainsi qu'une mise à jour du *building tree* et de la liste des simplifications potentielles (voir fig 4). En effet, appliquer une simplification peut affecter plusieurs simplifications potentielles. Cette remise à jour de la liste des simplifications potentielles doit s'effectuer localement. Divers cas peuvent perturber cette liste lors de l'application d'une simplification :

- Suppression d'un sommet. Dans ce cas, on met à jour les simplifications potentielles et les triangles concernées par ce sommet ;
- Suppression de triangles lors d'une simplification de bâtiments non connexes. De même, une mise à jour est effectué exclusivement sur les simplifications potentielles concernées par ces triangles supprimés.

L'algorithme se termine lorsque tout les bâtiments ont été fusionnés, autrement dit, quand la liste des simplifications potentielles est vide.

**4 Application en réseau envisagée**

4.5 Vue d'ensemble

Un modèle complet du système client/serveur est présenté en fig 5. Nous présentons seulement la partie concernant la transmission et la visualisation de la géométrie des bâtiments à l'aide du *Building Tree,* sans détailler les modules concernant le terrain et les textures. Pour ce qui est de la sélection des noeuds du *building tree* devant être raffinés chez le client, plusieurs modes sont envisageables :

-    *Mode PULL :* Le client décide lui même des noeuds devant être développés et envoie une requête au serveur (index du noeud à développer), afin que celui-ci lui fournisse l'information nécessaire au développement du noeud (nouveaux sommets, et les indexes des sommets constituant les nouveaux bâtiments). Le traitement de sélection des noeuds à développer s'effectuant chez le client, le serveur n'a plus qu'un rôle, répondre aux requêtes des clients en transmettant l'information nécessaire aux développement des noeuds. Ainsi, il est envisageable de connecter un nombre important de clients à un même serveur.
-    *Mode PUSH :* Le serveur conserve le contexte de chaque client lui permettant de sélectionner les noeuds devant être développés (le client lui transmet régulièrement sa position). Dans ce cas, le serveur gère à la fois la sélection des noeuds à développer, et la transmission des données. Ce mode permet d'alléger la charge du client, mais n'est pas envisageable dans le cas d'un nombre important de clients connectés.

Suivant le type d'utilisation envisagé, permettant la connexion d'un nombre plus ou moins important de clients, le mode *PULL* ou PUSH sera utilisé.

**4.6 Sélection des noeuds à développer**

Pour déterminer quel noeud doit être en priorité développé chez le client, il est nécessaire de déterminer un critère de raffinement. Pour cela nous allons comparer deux fonctions de coût, l'une prenant en compte des critères de perception (distance de l'objet au point de vue, vélocité du point de vue, ...), l'autre des critères de fidélité entre le modèle raffiné et le modèle original (différence de volume, comparaison de la projection des deux modèles, ...).

Sur la figure 6, *f* représente la fonction associée aux critères de perception prenant en paramètres le noeud courant *(bn),* la distance du noeud courant *bn* au point de vue *(distance),* la vélocité du point de vue *(velocité),* et tout autre paramètre de perception. La fonction g associée aux critères de fidélité du niveau de détail par rapport au modèle original prend en paramètres la différence de volume entre le bâtiment courant correspondant au noeud *bn* et les bâtiments originaux qu'il représente(dif *f-volume),* la différence entre la projection du bâtiment courant et celle des bâtiments originaux(di *f f-projection),* ainsi que tout autre paramètre permettant d'expliciter l'erreur due à cette représentation plus grossière sous forme de niveaux de détails.

**4.7 Transmission des données**

Pour développer un noeud du *building tree Bn,* seule l'information complémentaire permettant de définir les noeuds fils *Bni est* nécessaire

-    Les nouveaux sommets : La plupart des sommets constituant les noeuds fils *Bni* étaient déjà référencés dans le noeud *Bn.* Seules les coordonnées des nouveaux sommets seront transmises au client.

-    Les index des sommets : Il est nécessaire, pour définir les emprises au sol des bâtiments des fils de *Bn,* de transmettre les index des sommets les constituant.

-    Les paramètres de reconstruction : Ces paramètres englobent toutes les informations nécessaires permettant d'obtenir un modèle 3D du bâtiment plus ou moins complexe. Ces paramètres comprennent l'altitude, la hauteur du bâtiment, l'index de la texture de la façade, un type de toit, un type de fenêtre, ...

**4.7.1 Transmission de nouveaux sommets**

Pour transmettre les coordonnées des nouveaux sommets, on prend comme référence le centre de gravité cg de l'emprise au sol de *Bn.* Les emprises au sol des bâtiments de la ville nous sont fournies avec une précision e. Pour un sommet p, on transmet donc le couple (xp - xcp,yp - ycp) avec une précision de e. Ainsi, si pour l'ensemble des nouveaux sommets pi, on a :

EP 1 455 308 A1

$$\forall i, 2^{j+1} > MAX_i(MAX(x_{pi} - x_{cg}), MAX(y_{pi} - y_{cg}))/\in \, > 2^j \tag{10}$$

on peut coder les coordonnées des nouveaux sommets référencés par rapport à cg sur j + 1 bits.

### 4.7.2 Transmission des index des sommets

Dans le cas d'un sommet déjà présent dans Bn, on transmet l'index du sommet dans *Bn* (sa position dans le polygone définissant l'emprise au sol de *Bn),* sinon, s'il s'agit d'un nouveau sommet, on transmet l'index du sommet dans le tableau des nouveaux sommets transmis précédemment.

### 4.8 Reconstruction 3D et visualisation

### 4.8.1 Reconstruction *3D*

**Reconstruction simpliste :** La reconstruction la plus simpliste d'un bâtiment s'effectue par l'extrusion de son emprise au sol, à partir de l'altitude et de la hauteur du bâtiment. Un certain nombre de paramètres permettent de calculer les coordonnées textures façades, comme la taille réelle de la texture, le nombre d'étages, la taille du rez-de-chaussé, le nombre de fenêtres sur un étage. A partir des ces paramètres de texture façade, des opérations de découpage et de duplication sont effectuées afin de conserver une certaine cohérence lors du plaquage des textures. Pour les textures du toit, on plaque la texture du sol (puisque les textures du sol sont des photos aériennes comprenant à la fois le sol et les toits).

**Reconstruction détaillée :** Pour obtenir un modèle plus complexe de bâtiment, il est envisageable de calculer le squelette de l'emprise au sol du bâtiment, permettant ainsi la reconstruction du toit. Un reconstruction des fenêtres est aussi envisageable, à condition d'avoir transmis une grille définissant l'emplacement des fenêtres sur la façade, ainsi que le modèle 3D de fenêtre correspondant. Tout type de méthodes procédurales de reconstruction 3D se basant sur l'emprise au sol du bâtiment est envisageable.

### 4.8.2 Visualisation

Le rendu 3D s'effectue à l'aide de la bibliothèque OpenGL. Seule les feuilles du *building tree* dont une reconstruction 3D a été effectuée sont transmises à la carte graphique, afin d'être visualisées. En cas de surcharge de la carte graphique, impliquant des taux de rafraîchissement trop faibles, certains noeuds du *building tree* peuvent être repliés afin de limiter le nombre de polygones à afficher.

Pour ce qui est des textures terrain, très volumineuses, une représentation progressive est utilisée, du type *JPEG2000.*

### Résumé

Comme on l'aura compris, la méthode qui vient d'être décrite est une nouvelle approche permettant de représenter des scènes modélisées à partir d'un ensemble de prismes à différentes résolutions. Le but réel de cette représentation est de permettre la navigation dans de vastes environnements urbains sur un système client/serveur. Grâce à cette méthode, la navigation via le réseau n'est plus seulement limitée à une navigation au niveau du sol, mais autorise aussi le survol de la ville. Pour obtenir ce résultat, l'algorithme fusionne et simplifie les prismes (ou, dans notre cas, les bâtiments de la ville) afin de générer plusieurs niveaux de détail de la scène. Étant donné les techniques de modélisation automatique de scènes urbaines basées sur le traitement de données 2D1/2 (vidéo, photographies, plan cadastral, ...), l'algorithme traite seulement prismes ou données dites 2D1/22 (emprise au sol, hauteur et altitude des bâtiments) aussi complètes qu'une représentation 3D pour le cas particulier des bâtiments d'une ville. A partir de cette représentation des bâtiments pré-calculée sous forme de prismes multi-échelles, le serveur transmettra progressivement au client uniquement les détails réellement perceptibles pour toute la région vue d'un certain point de vue.

Références

[1]Jonathan Cohen, Amitabh Varshney, Dinesh Manocha, Greg Turk, Hans Weber, Pankaj Agarwal, Frederick Brooks, and William Wright. Simplification envelopes. *SIGGRAPH* 96 *Conference Proceedings,* pages 119-128, 1996.

[2]X. Decoret, G. Schaufler, F. Sillon, and J. Dorsey. Multi-layered impostors for accelerated rendering. In *Eurographics'99,* volume 18, 1999.

[3] Michel Garland and Paul Heckbert. Surface simplification using quadric error metrics. *SIGGRAPH* 97 *Conference Proceedings,* pages 209-216, 1997. Michel Garland and Paul Heckbert. Simplifying surfaces with color and texture using quadric error metrics. *IEEE Visualization* 98 *Conference Proceedings,* 1998.

[5] H. Hoppe. View-dependent refinement of progressive meshes. In *Computer Graphics SIGGRAPH* 97, volume 31, pages 189-198, New York, 1997. ACM Press.

[6] Hugues Hoppe. Progressive meshes. *SIGGRAPH* 96 *Conference Proceedings,* pages 99-108, 1996.

[7] Hugues Hoppe. New quadric metric for simpliying meshes with apperance attributes. *VISUALIZA TION* 99 *Conference Proceedings,* 1999. http://research.microsoft.com/-hoppe/.

[8]D. Luebke and C. Erikson. View-dependent simplification of arbitrary polygonal environnements. In *Computer Graphics SIGGRAPH 97,* volume 31, pages 199-208, New York, 1997. ACM Press.

[9]Y.I.H Parish and P. Müller. Procedural modeling of cities. In *Computer Graphics SIGGRAPH 2001,* pages 301-308. ACM Press, 2001.

[10] H. Pfister, M. Zwicker, J. Van Baar, and M. Gross. Surfels: Surface elements as rendering prinitives. In *Computer Graphics, SIGGRAPH 2000 Proceeding,* pages 343-352, Los Angeles, 2000.

[11] William J. Schroeder, Jonathan A. Zarge, and William E. Lorensen. Decimation of triangle meshes. In *Proceedings of the 19th annual conference on Computer graphics and interactive techniques,* pages 65-70. ACM Press, 1992.

[12] Seth J. Teller and Carlo H. Sequin. Visibility preprocessing for interactive walkthroughs. *Computer Graphcis (proceedings of SIGGRAPH* 91), 25(4):61-69, 1991.

[13] S. Volz and M. Sester. Nexus - distributed data management concepts for location aware applications. In International Workshop *on emerging technologies for geo-based applications,* Ascona, Switzerland, 2000.

[14] Michael Wimmer, Peter Wonka, and François Sillion. Point-based impostors for real-time visualization. In *EuroGraphics Workshop on Reudering,* 2001.

[15] P. Wonka and D. Scmalstieg. Occluder shadows for fast walkthrougs of urban environnements. In *EUROGRAPHICS' 99,* volume 18, 1999.

[16] P. Wonka, Michael Wimmer, and F.X. Sillion. Instant visibility. In *Eurographics 2001,* volume 20, 2001.

[17] Peter Wonka, Michael Winner, and Dieter Schmasteig. Visibility preprocessing with occluder fusion for urban walkthroughs. In *Eurographics Workshop on Rendering,* 2000.

## Revendications

1. Procédé pour la gestion de la représentation d'au moins une scène modélisée comprenant des bâtiments destinée à être transmise par des moyens de mémorisation à un client, ladite scène étant modélisée par une représentation multi-échelle arborescente, dans laquelle on associe à différents niveaux de détails de la scène différents noeuds, ces différents noeuds étant dépendants les uns des autres dans une arborescence dans laquelle au moins un noeud fils est défini par des informations connues d'un noeud père et par des informations complémentaires, les informations stockées par les moyens de mémorisation pour le noeud fils étant ces informations complémentaires, **caractérisé en ce qu'**on met en oeuvre sur la modélisation un traitement de simplification de représentation et **en ce qu'**on détermine des priorités de mises en oeuvre de traitements de simplification en déterminant une fonction de coût qui prend en compte le critère de la différence de hauteur des bâtiments fusionnés.

2. Procédé selon la revendication 1, caractérisé les informations de représentation de la scène modélisée sont transmises de façon progressive par les moyens de mémorisation au client.

3. Procédé selon l'une des revendications 1 ou 2, **caractérisé en ce que** la scène représentée est celle d'une ville et de bâtiments de celle-ci.

4. Procédé selon l'une des revendications précédentes, **caractérisé en ce que** chaque noeud comporte notamment les informations suivantes :

   - une référence,
   - une emprise au sol (polygone indexé par rapport au tableau des sommets),
   - une hauteur,
   - une altitude,
   - un type de toit,
   - tout autres paramètres permettant de modéliser de manière procédurale la géométrie 3D du bâtiment,
   - les références vers le noeud père et les noeuds fils.

5. Procédé selon l'une des revendications précédentes, **caractérisé en ce qu'**on met en oeuvre une réduction du nombre de façades d'un bâtiment en respectant les contraintes suivantes :

   - Un seul sommet est supprimé à chaque réduction du nombre de façades d'un bâtiments, ce sommet ne devant pas être partagé par une autre emprise au sol de bâtiment.
   - La suppression du sommet ne doit pas engendrer d'intersections entre le bâtiment simplifié et les bâtiments avoisinants.
   - L'aire de l'emprise au sol du bâtiment simplifié doit être la plus proche de l'aire de l'emprise au sol du bâtiment originale.

6. Procédé selon l'une des revendications 1 à 5, **caractérisé en ce que** on met en oeuvre une fusion de bâtiments connexes par une façade en fusionnant des emprises au sol de deux bâtiments, la hauteur du bâtiment résultant étant une moyenne de la hauteur des deux bâtiments pondérée par leurs surfaces respectives, et l'altitude étant l'altitude minimale des deux bâtiments originaux, assurant ainsi au bâtiment généré d'être plaqué au sol.

7. Procédé selon l'une des revendications 1 à 5, **caractérisé en ce que** en met en oeuvre un traitement de fusion de bâtiments non connexes

8. Procédé selon la revendication 7, **caractérisé en ce que** pour fusionner potentiellement des bâtiments non connexes par une arête, on effectue une triangulation dans l'espace vide sans point de Steiner.

9. Procédé selon l'une des revendications précédentes, **caractérisé en ce que** la fonction de coût déterminée pour déterminer les priorités de mises en oeuvre de traitements de simplification prend en outre en compte les critères suivants :

   - La différence d'altitude des bâtiments fusionnés
   - La surface supplémentaire engendrée par la fusion
   - La distance minimale entre les bâtiments fusionnés

10. Procédé selon l'une des revendications précédentes, **caractérisé en ce que** la représentation d'au moins une scène modélisée est transmise par les moyens de mémorisation au client en mode « Pull » : le client décidant lui même des noeuds devant être développés et envoyant une requête auxdits moyens, afin que celui-ci lui fournisse l'information nécessaire au développement du noeud.

11. Procédé selon l'une des revendications 1 à 10, **caractérisé en ce que** la représentation d'au moins une scène modélisée est transmise par les moyens de mémorisation au client en mode « Push », lesdits moyens conservant le contexte de chaque client lui permettant de sélectionner les noeuds devant être développés.

12. Système client/serveur, **caractérisé en ce qu'**il comporte un serveur qui comprend des moyens de traitement pour mettre en oeuvre un procédé selon l'une des revendications précédentes.

Building Tree
(Emprise des bâtiments au sol)

Tableau des
sommets associés

Niveau 0

Niveau 1

Niveau 2

## FIG.1

## FIG.2

## Cas classiques

a, Suppression d'un
sommet

b, Fusion de bâtiments
connexes par une arête

c, Fusion de bâtiments non
connexes par une arête

## Cas particuliers traités

d, Fusion de bâtiments
connexes par une arête

e, Fusion de bâtiments non
connexes par une arête

f, Fusion de bâtiments non
connexes par une arête

## Cas particuliers non traités

g, Suppression d'un sommet
impossible si celui-ci appartient
à un autre bâtiment

h, Triangulation ne se prêtant pas à
la fusion de A et C mais de A et B

# FIG.3

A+B=>F
C=>G
D+E=>H
G+H=>J
I+J=>K

Liste des simplifications
potentielles ordonnées
suivant leurs coûts

Building tree

Séquence des emprises de bâtiments au sol formant
la représentation progressive

# FIG.4

**Serveur**

Modèle structuré de la ville (2D1/2 & 3D)

Terrain (ondelettes)
Texture (ondelettes)
Géométrie 2D1/2(shape) & 3D

Sélection de la géo & texture à envoyer au clients

Représentation cache clients

Pré-calcul

Génération de LOD progressifs

Partitionnement + visibilité (PVS)

Base de données de la ville (2D1/2 & 3D)

**RESEAU**

Position de l'observateur

**Client**

Cache Terrain

Cache Texture

Cache Géo | 3D | 2D1/2

Modeleur

Gestion de cache

Sélection du LOD à afficher

Pipeline

Rendu

Fréquence d'affichage

☐ Modules concernant la représentation multi-échelle des bâtiments

FIG.3

EP 1 455 308 A1

16

i =0

Building No de bn = Feuille(i)

si f(bn, distance, vélocité, ...)<g(bn, diff_volume, diff_projection, ...)

alors

sinon

Développer bn

si il existe Feuille(i+1)

alors i++

sinon i=0

Building No de bn = Parent(Feuille(i))

si f(bn, distance, vélocité, ...)>g(bn, diff_volume, diff_projection, ...)

alors

sinon

Replier bn

si il existe Feuille(i+1)

alors i++

sinon fin

## FIG.6

**Office européen
des brevets**

**RAPPORT DE RECHERCHE EUROPEENNE**

Numéro de la demande

EP 04 29 0607

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | M KOFLER: "r-trees for visualizing and organizing large 3D gis databases-dissertation" THESIS, [Online] 1 juillet 1998 (1998-07-01), pages 1-164, XP002259173 Graz.AT Extrait de l'Internet: URL:http://www.icg.tu-graz.ac.at/kofler/th esis> [extrait le 2003-10-24] * page 46, ligne 3 - page 58, ligne 12 * * page 75, ligne 35 - page 78, ligne 6 * * page 106, ligne 16 - page 117, ligne 11 * | 1-4,12 | G06T17/00 |
| A | THIEMANN: "generalization of 3D building data" IAPRS.PART4: "GEOSPATIAL THEORY, PROCESSING AND APPLICATIONS", [Online] vol. 34, 2002, pages 1-5, XP002259174 otawa. CA Extrait de l'Internet: URL:www.ikg.uni_hannover.de/publikationen/ 2002/isprs_thiemann_2002pdf> [extrait le 2003-10-24] * abrégé; figure 4 * | 1-3 | |

-/--

**DOMAINES TECHNIQUES
RECHERCHES (Int.Cl.7)**

G06T

Le présent rapport a été établi pour toutes les revendications

| Lieu de la recherche | Date d'achèvement de la recherche | Examinateur |
|---|---|---|
| La Haye | 28 juin 2004 | Perez Molina, E |

**Office européen des brevets**

## RAPPORT DE RECHERCHE EUROPEENNE

Numéro de la demande

EP 04 29 0607

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | CH. ZACH ET AL.: "modelling and visualizing the cultural heritage fata set of graz" INTERNATIONAL SYMPOSIUM ON VIRTUAL REALITY, ARCHEOLOGY AND CULTURAL HERITAGE (VAST 2001), [Online] 2001, pages 1-8, XP002259175 glyfada, GR Extrait de l'Internet: URL:http://www.icg.tu-graz.ac.at/www.vrvis.at/research/publications.html> [extrait le 2003-10-24] * page 2, alinéa 4.1 - page 6, alinéa 4.1.3; figures 7-9 * ----- | 5 | |
| A | LAYCOCK ET AL.: "automatically generating roof models from building footprints" WSCG POSTERS PROCEEDINGS, [Online] 3 février 2003 (2003-02-03), pages 1-4, XP002259201 CZ Extrait de l'Internet: URL:wscg.zcv.cz/wscg2003/papers_2003/g67.pdf> [extrait le 2003-10-24] * page 2, colonne de gauche, ligne 1 - colonne de droite, ligne 1; figure 1 * ----- | 5 | DOMAINES TECHNIQUES RECHERCHES (Int.Cl.7) |

Le présent rapport a été établi pour toutes les revendications

| Lieu de la recherche | Date d'achèvement de la recherche | Examinateur |
|---|---|---|
| La Haye | 28 juin 2004 | Perez Molina, E |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)